# EUROPEAN PATENT APPLICATION

(11) **EP 4 637 028 A1**
(43) Date of publication of application: **22.10.2025**
(21) Application number: 25168713.3
(22) Date of filing: 04.04.2025
(51) Int. Cl.: H03F 1/02, H03F 3/24, H03F 3/68

(54) **STAGED ACTIVATION OF SWITCHES FOR SYMBOL BASED ENVELOPE TRACKING**

(30) Priority: 18.04.2024 US 202463635794 P
(71) Applicant: Analog Devices, Inc., Wilmington, MA 01887 (US)
(72) Inventor: Sapia, Gary A., Wilmington, 01887 (US); Gardner, Andrew J., Wilmington, 01887 (US)
(74) Representative: Wallin, Nicholas James

(57) **Abstract**

Aspects of this disclosure relate to voltage modulators with staged activation of switches. A voltage modulator can receive supply voltages and provide a selected one of the supply voltages as an output voltage. The voltage modulator can include switches in parallel where one of the switches in parallel activates before another switch in parallel in association by transitioning the output voltage between different supply voltages. Embodiments of this disclosure relate to symbol-based envelope tracking. Related systems and methods are disclosed.

## Description

### CROSS REFERENCE TO PRIORITY APPLICATION

This application claims the benefit of priority of U.S. Provisional Application No. 63/635,794, filed April 18, 2024 and titled "STAGED ACTIVATION OF SWITCHES FOR SYMBOL BASED ENVELOPE TRACKING," the disclosure of which is hereby incorporated by reference in its entirety and for all purposes.

### BACKGROUND

### TECHNICAL FIELD

Embodiments of this disclosure relate to generating a bias voltage for a power amplifier, where the bias voltage tracks an envelope of a radio frequency signal.

### DESCRIPTION OF RELATED TECHNOLOGY

Radio systems can transmit and receive signals in the form of electromagnetic waves having a frequency in range from approximately 30 kilohertz (kHz) to 300 Gigahertz (GHz). Radio systems can be used for wireless communications, such as cellular communications and/or other wireless network communications.

Radio systems that transmit signals often include a power amplifier to amplify a radio frequency signal for transmission via one or more antennas. Power amplifiers can consume significant power in such systems. Power efficient power amplifiers can be desirable for a variety of applications.

### SUMMARY OF CERTAIN INVENTIVE ASPECTS

The innovations described in the claims each have several aspects, no single one of which is solely responsible for its desirable attributes. Without limiting the scope of the claims, some prominent features of this disclosure will now be briefly described.

One aspect of this disclosure is a system with staged activation of switches for symbol-based envelope tracking. The system includes a voltage modulator and a power amplifier. The voltage modulator is configured to receive a plurality of supply voltages and to output a selected one of the plurality of supply voltages at an output node based on a symbol-based envelope tracking state. The voltage modulator includes a first switch, a second switch in parallel with the first switch, and a third switch. The first switch is configured to activate after the second switch in association with the symbol-based envelope tracking state transitioning from a first state to a second state. The first switch and the second switch are configured to pass a first supply voltage to the output node in the second state. The third switch is configured to pass a second supply voltage to the output node in the first state. The power amplifier is electrically connected to the output node. The power amplifier is configured to amplify a radio frequency signal.

The first switch can occupy more physical area than the second switch.

The voltage modulator can include a fourth switch in parallel with the third switch. The third switch can activate after the fourth switch in association with the symbol-based envelope tracking state transitioning from the second state to the first state.

The power amplifier can include a gallium nitride transistor.

A voltage at the output node can have a higher voltage level in the second state than in the first state. The voltage at the output node in the first state can be greater than 0 Volts. The voltage at the output node in the first state can be at least one quarter of the voltage at the output node in the second state.

The first switch and the second switch can be field effect transistors.

The first switch can include a pair of sub-switches with magnetic field cancellation.

The voltage modulator can be configured to perform make before break switching.

The voltage modulator can be configured to transition a voltage at the output node between the first supply voltage and the second supply voltage in less than 50 nanoseconds. The first supply voltage and the second supply voltage can differ by at least one quarter of a higher of the first supply voltage and the second supply voltage.

A voltage at the output node can track an envelope of the radio frequency signal on a symbol-by-symbol basis.

Another aspect of this disclosure is a method of voltage multiplexing with staged activation of switches. The method includes providing a first supply voltage of a plurality of supply voltages as an output voltage using a switch in a first state; activating a pair of parallel switches in association with transitioning from the first state to a second state such that a second switch of the pair of parallel switches activates before a first switch of the pair of parallel switches; and providing a second supply voltage of the plurality of supply voltages as the output voltage using the pair of parallel switches in the second state, wherein the first supply voltage and the second supply voltage are at different discrete non-zero voltage levels when provided as the output voltage.

The method can include biasing a power amplifier with the output voltage and amplifying a radio frequency signal with the power amplifier. The first state and the second state can be symbol-based envelope tracking states associated with symbols of the radio frequency signal. The output voltage can track an envelope of the radio frequency signal on a symbol-by-symbol basis.

Activating can occur on a symbol boundary of a radio frequency signal amplified by a power amplifier that receives the output voltage.

The first switch can occupy more physical area than the second switch.

The method can include activating a second pair of parallel switches in association with transitioning from the second state to the first state such that a fourth switch activates before a third switch, in which the second pair of parallel switches includes the third switch and the fourth switch.

Another aspect of this disclosure is a voltage modulator with staged activation of switches. The voltage modulator includes a first switch, a second switch in parallel with the first switch, and a third switch. The first switch is configured to activate after the second switch in association with transitioning from a first state to a second state. The first switch and the second switch are configured to pass a first supply voltage to an output node in the second state. The third switch is configured to pass a second supply voltage to the output node in the first state. The voltage modulator is configured to receive a plurality of non-zero supply voltages including the first supply voltage and the second supply voltage.

The voltage modulator can be configured to perform make before break switching. The first switch can occupy more physical area than the second switch.

The first switch can include a pair of sub-switches with magnetic field cancellation.

For purposes of summarizing the disclosure, certain aspects, advantages and novel features of the innovations have been described herein. It is to be understood that not necessarily all such advantages may be achieved in accordance with any particular embodiment. Thus, the innovations may be embodied or carried out in a manner that achieves or optimizes one advantage or group of advantages as taught herein without necessarily achieving other advantages as may be taught or suggested herein.

### BRIEF DESCRIPTION OF THE DRAWINGS

Embodiments of this disclosure will be described, by way of non-limiting example, with reference to the accompanying drawings.
Figure 1 is a waveform of a radio frequency (RF) signal and a modulated bias voltage that changes on a symbol-by-symbol basis.
Figure 2 is a schematic block diagram of a multiple-input, multiple-output (MIMO) radio system according to an embodiment.
Figure 3 is a schematic diagram of a radio transmitter channel with a dual input bias voltage multiplexer for biasing an RF power amplifier.
Figure 4A is a schematic diagram a dual input, single output symbol-based envelope tracking (SBET) voltage modulator. Figures 4B, 4C, 4D, and 4E are graphs associated with operation of the SBET voltage modulator of Figure 4A.
Figure 5A is a schematic diagram a dual input, single output SBET voltage modulator with an RC snubber. Figures 5B, 5C, 5D, and 5E are graphs associated with operation of the SBET voltage modulator of Figure 5A.
Figure 6A is a schematic diagram a dual input, single output SBET voltage modulator with parallel switches with staged activation. Figures 6B, 6C, 6D, and 6E are graphs associated with operation of the SBET voltage modulator of Figure 6A.
Figure 7 is a schematic diagram of sub-switches of a switch and associated bypass capacitors with magnetic field cancellation.

### DETAILED DESCRIPTION OF CERTAIN EMBODIMENTS

The following detailed description of certain embodiments presents various descriptions of specific embodiments. However, the innovations described herein can be embodied in a multitude of different ways, for example, as defined and covered by the claims. In this description, reference is made to the drawings where like reference numerals can indicate identical or functionally similar elements. It will be understood that elements illustrated in the figures are not necessarily drawn to scale. Moreover, it will be understood that certain embodiments can include more elements than illustrated in a drawing and/or a subset of the illustrated elements. Further, some embodiments can incorporate any suitable combination of features from two or more drawings. The headings provided herein are for convenience only and do not necessarily affect the scope or meaning of the claims.

A rapidly growing use of power supplies is to bias radio frequency (RF) power amplifiers (PAs) in multiple-input multiple-output (MIMO) cellular radios. These PAs may be configured as linear amplifiers, instead of Class-D amplifiers or other switching amplifiers, due to specifications to support high frequency transmission. Two or more power supply voltages may be used to modulate the bias voltage of the PA between two or more discrete voltage levels to track an RF envelope of a signal being amplified by the PA on a symbol-by-symbol basis to reduce and/or minimize power dissipation.

Aspects of this disclosure relate to achieving clean, fast, rising and/or falling-edge transitions at the output of a voltage modulator. The voltage modulator can be used for symbol-based envelope tracking (SBET). The voltage modulator can include a pair of parallel switches with staged activation that provides fast transition times between discrete output voltage levels without creating excessive overshoots and/or power dissipation. A smaller switch of the pair of parallel switches can activate before the larger switch of the pair of parallel switches in association with a transition between discrete output voltage levels. The transition can be associated with toggling an SBET state. The switches can include field effect transistors. For example, the switches can include enhancement mode metal oxide field effect transistors in certain applications.

### SBET Envelope Tracking

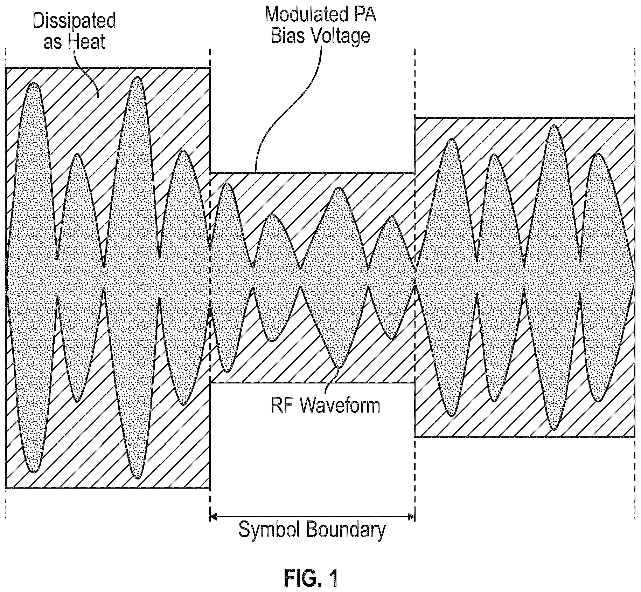

Figure 1 illustrates an example waveform where the PA bias voltage is modulated on a symbol-by-symbol basis to reduce power dissipation. The PA bias voltage is modulated as a function of the RF waveform. Such bias voltage modulation can reduce power dissipation by the PA. Dissipated heat can correspond to a difference between the RF waveform and the PA bias voltage. The PA bias voltage can toggle among discrete voltage levels on a symbol-by-symbol basis. Such a technique can be referred to as symbol-based envelope tracking (SBET). The PA bias voltage can track a root mean square symbol power of a RF signal in SBET.

In SBET, a PA transistor output terminal bias voltage (e.g., drain bias voltage) may only change on symbol boundaries, for example, as shown in the Figure 1. The bias voltage provided to a PA transistor output terminal (e.g., a drain of a PA field effect transistor) can have a generally constant voltage level for an entire symbol in SBET while the envelope of the waveform has multiple peaks and troughs for the symbol. The PA transistor output terminal bias voltage can support a maximum peak power within a symbol. This can improve PA efficiency relative to a using fixed PA bias voltage. At the same time, SBET can be implemented with less complexity and with a slower switching time than continuous envelope tracking.

In the case of mixed numerology carriers (for example, in fifth generation New Radio), the symbols lengths are shorter for the higher numerologies. In this case, SBET can switch at the symbol boundaries of the highest numerology carrier in some instances. Alternatively, SBET can switch at the symbol boundaries of the lowest numerology carrier in some other instances. In either mixed numerology carrier case, a bias voltage provided by a SBET voltage modulator may change only on symbol boundaries and the bias voltage is generally constant during each symbol.

Any suitable combination of features of SBET disclosed in one or more of U.S. Patent Publication No. 2024/0405725, U.S. Patent Publication No 2025/0015769, or U.S. Patent Publication No. 2025/0015762 can be implemented in combination with SBET features disclosed herein. The technical disclosures of each of U.S. Patent Publication No. 2024/0405725, U.S. Patent Publication No 2025/0015769, and U.S. Patent Publication No. 2025/0015762 are hereby incorporated by reference in their entireties and for all purposes.

### Radio Systems and Transmitter Channels

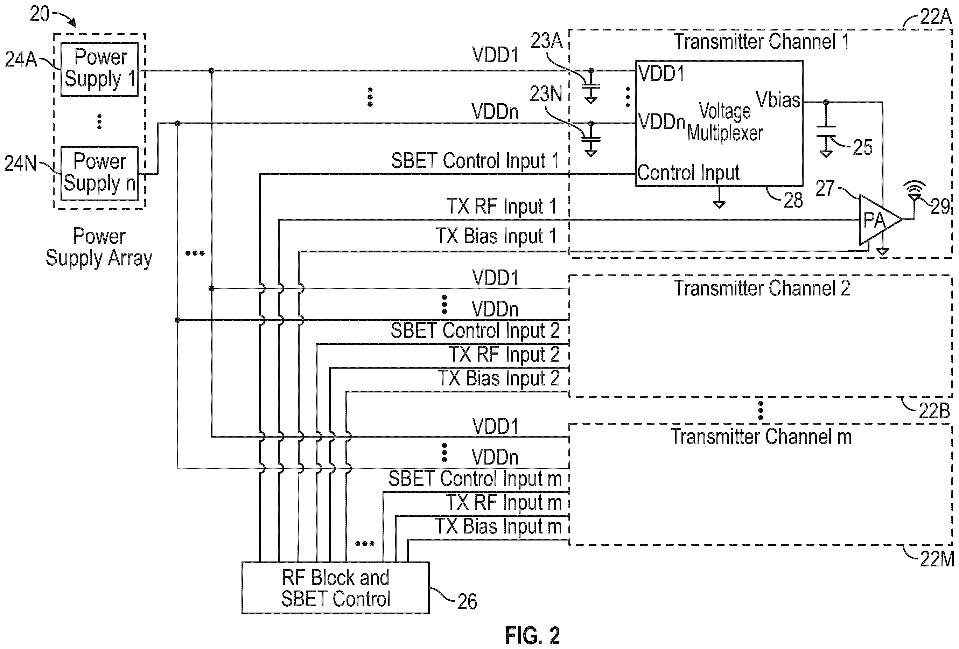

Figure 2 is a schematic block diagram of an example MIMO radio system 20 according to an embodiment. As illustrated, the MIMO radio system 20 includes a plurality of transmitter channels 22A, 22B, 22M, a plurality of power supplies 24A, 24N, and an RF and SBET control block 26. The transmitter channels 22A, 22B, 22M can be referred to as RF PA transmitter channels. The plurality of transmitter channels 22A, 22B, 22M can each include a PA 27, bypass capacitors 23A to 23N, a voltage multiplexer 28, and an antenna 29. A load capacitance 25 is also illustrated in the transmitter channel 22A. A voltage modulator circuit can include the bypass capacitors 23A, 23N and the voltage multiplexer 28. Any suitable positive integer number M of transmitter channels can be implemented. In certain applications, there can be 8 to 128 transmitter channels. For example, there can be 32, 64, or 128 transmitter channels in some applications.

The voltage multiplexer 28 can implement SBET biasing of the PA 27. The voltage multiplexer 28 can have two or more supply voltage inputs and one output. The supply voltage inputs of the voltage multiplexer 28 are configured to receive voltages generated from respective power supplies 24A, 24N. As illustrated in Figure 2, the power supplies 24A, 24N can be included in a power supply array. Any suitable positive integer number N of power supplies can be implemented. For example, in certain applications, there can be 2 power supplies or 4 power supplies. The output of the voltage multiplexer 28 can be connected to the PA 27 to provide a bias voltage Vbias for the PA 27. Input bypass capacitors 23A and 23N can be positioned in proximity with the voltage multiplexer 28 to reduce and/or minimize parasitic inductance.

Power supply voltages VDD1 to VDDn from the power supplies 24A, 24N can be provided to two or more transmitter channels 22A, 22B, 22M. The power supplies 24A to 24N can be implemented as discrete voltage sources. The power supplies 24A to 24N can be implemented as voltage sources in series. Each of the power supplies 24A to 24N can provide a non-zero supply voltage.

The RF and SBET control block 26 can generate an RF input signal (e.g., one of TX RF Input 1 to TX RF Input M) for the PA 27, a second bias input signal (e.g., one of TX Bias Input 1 to TX Bias Input M) for the PA 27, and one or more voltage multiplexer control signals (e.g., one of SBET Control Input 1 to SBET Control Input M) for each transmitter channel 22A to 22M. The one or more voltage multiplexer control signals can control switches of the voltage multiplexer 28 to select a bias voltage Vbias that tracks the envelope of the RF signal. Each voltage multiplexer 28 can include a decoder to decode the one or more voltage multiplexer control signals in certain applications. A voltage level of the bias voltage Vbias can be adjusted corresponding to symbol boundaries of the RF signal. The bias voltage Vbias can track the envelope of the RF signal on a symbol-by-symbol basis. In some instances, the bias voltage Vbias can track the envelope of the RF signal for a group of symbols and/or for each individual symbol. The bias voltage Vbias can be applied to an output (e.g., a drain) of the PA 27. The second bias input signal for the PA 27 can be a bias signal for an input terminal (e.g., a gate) of the PA 27.

The power delivered from the power supplies 24A, 24N can be limited by circuit breakers and/or fuses. Alternatively, the voltage multiplexer 28 can incorporate electronic circuit breaker protection. In such instances, the voltage multiplexer 28 of each transmitter channel 22A to 22M can provide electronic circuit breaker protection.

The PA 27 can amplify the RF input signal. The PA 27 can be implemented by any suitable transistors. In certain applications, the PA 27 can include a gallium nitride (GaN) field effect transistor. The antenna 29 can be coupled to the output of the PA 27. The antenna 29 can transmit an output signal. Antennas 29 of the transmitter channels 22A, 22B, 22M can perform beamforming in certain applications.

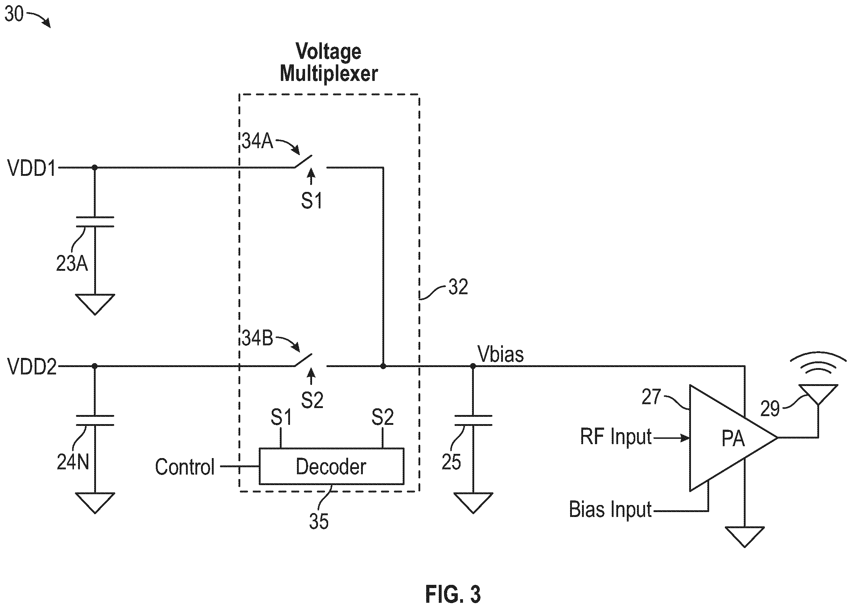

Figure 3 is a schematic diagram of a transmitter channel 30 with a dual input bias voltage multiplexer 32 for biasing a PA 27. The transmitter channel 30 is configured to receive two different supply voltages VDD1 and VDD2. The voltage multiplexer 32 is configured to modulate the bias voltage Vbias by actuating switches 34A and 34B to selectively electrically connect input nodes at the supply voltages VDD1 and VDD2, respectively, to the output node that provides the bias voltage Vbias. The voltage multiplexer 32 can include a decoder 35 to control switching of the switches 34A and 34B to generate the bias voltage Vbias at discrete voltage levels. The decoder 35 can provide binary output signals to control switches 34A and 34B. The decoder 35 can decode a control signal Control. In some applications, the decoder 35 can receive a ternary level input control signal to actuate the switches 34A and 34B where the third level is decoded to open both switches simultaneously. The control signal Control can be provided by a control block, such as the RF and SBET control block 26 of Figure 2.

Modulation of the PA bias voltage Vbias can significantly reduce power dissipation. However, there are technical challenges associated with achieving fast settling transitions with a relatively small amount of overshoot for the output of the voltage multiplexer. For example, voltage modulators arranged to generate SBET bias voltages can have transition times of 10s of nanoseconds (ns) and voltage can be stepped significantly (e.g., from around 25 Volts (V) to around 50 V). This can result in a high slew rate. Staged activation of parallel switches in an SBET voltage modulator can achieve clean transitions without significant overshooting or ringing out.

### Edge Transitions for SBET Voltage Modulator

Achieving clean, fast, rising and falling-edge transitions at the output of a SBET voltage modulator can be desirable for preserving the integrity of the "0" symbol, which can be the first symbol after the rising or falling-edge transition. Fast-settling transitions with minimal over-shoot can also reduce and/or minimize one or more of device electrical over-stress (EOS), electro-magnetic interference (EMI), or power dissipation.

This disclosure provides a scheme for staged metal oxide semiconductor field effect transistor (MOSFET) switching that can meet a relatively fast transition time specification (e.g., < 50 nanoseconds) of a SBET voltage modulator without creating excessive overshoots and/or power dissipation.

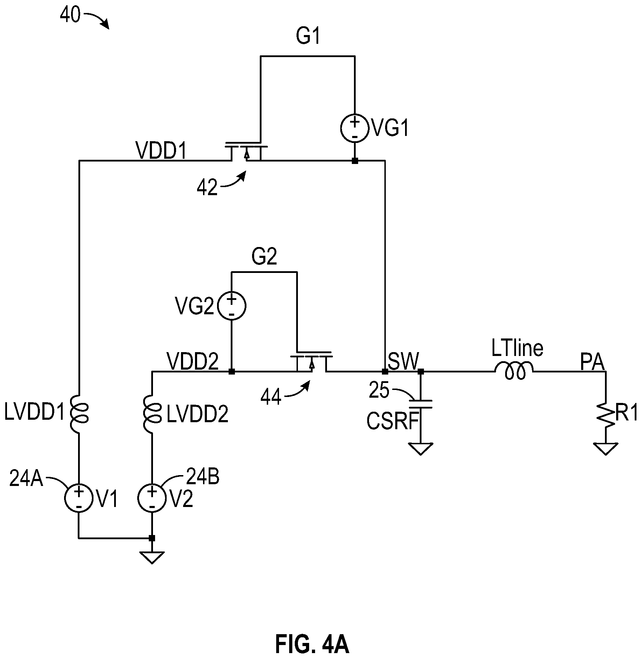

Figure 4A is a schematic diagram an implementation of a dual input, single output SBET voltage modulator 40. As illustrated, the SBET voltage modulator 40 includes a first field effect transistor 42 and a second field effect transistor 44. The field effect transistors 42 and 44 can implement the switches 34A and 34B, receptively, of Figure 3. A first supply voltage VDD1 can be provided to the first field effect transistor 42. A second supply voltage VDD2 can be provided to the second field effect transistor 44. The supply voltages VDD1 and VDD2 can be provided by power supplies 24A and 24B, respectively.

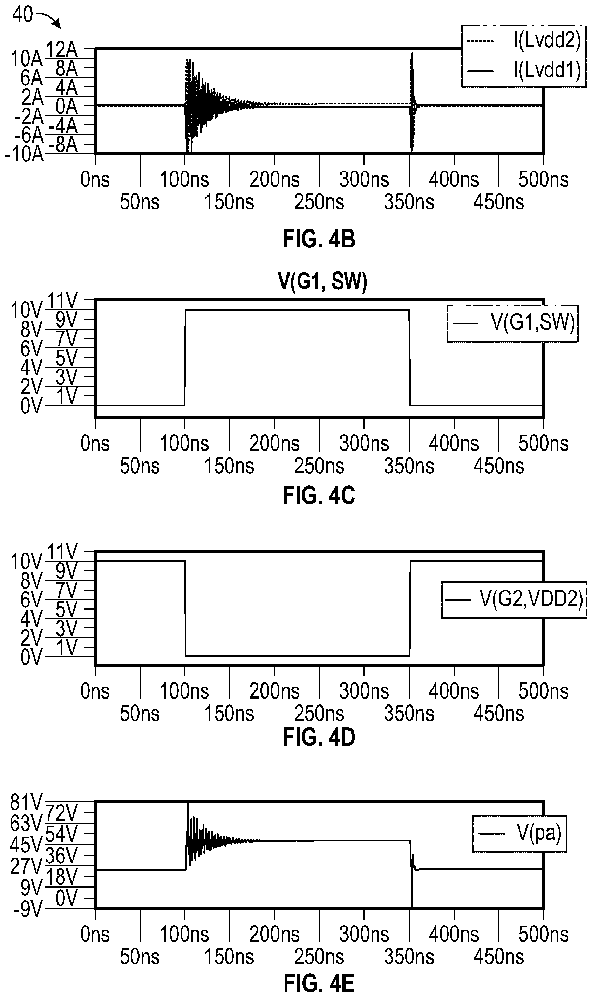

Figures 4B, 4C, 4D, and 4E are graphs associated with operation of the SBET voltage modulator 40 of Figure 4A. Figure 4B is a graph of current for the voltage supplies VDD1 and VDD2. Figure 4C is a graph of gate voltage for the first field effect transistor 42. Figure 4D is a graph of gate voltage for the second field effect transistor 44. Figure 4E is a graph of a bias voltage provided to a PA by the SBET voltage modulator 40. Figure 4E indicates that ringing can cause the bias voltage for the PA to be almost two times the target bias voltage.

With the SBET voltage modulator 40 of Figure 4A, substantial voltage over-shoots may be present at a switched output node SW, as well as corresponding supply voltage VDD1 and VDD2 supply current transients. These transients may be the result of energy storage in parasitic inductances such as a first parasitic inductance LVDD1 and a second parasitic inductance LVDD2. An effective series inductance (ESL) of a load capacitance 25 may be present by design to create a self-resonant impedance centered at the carrier frequency of the PA.

The first parasitic inductance LVDD1 and the second parasitic inductor LVDD2 can model the ESL typically found in the bypass capacitors for supply voltages VDD1 and VDD2, respectively. Such bypass capacitors can correspond to the bypass capacitors 24A and 24N of Figures 2 and/or 3. Inductor LTline can model the distributed inductance of a quarter-wavelength frequency transmission line connecting the switched output node SW to the PA load. The power amplifier load is illustrated as a resistor R1 in Figure 4A. The PA load can be a PA, such as the PA 29 of Figure 3.

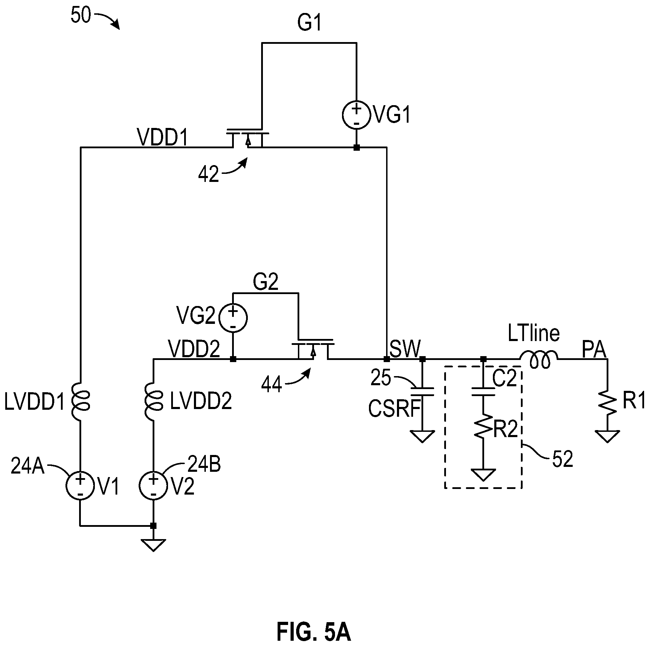

Figure 5A is a schematic diagram of an SBET voltage modulator 50. The SBET voltage modulator 50 is one solution for reducing and/or minimizing voltage over-shoots and/or under-shoots at a switched output node SW. The SBET voltage modulator 50 is like the SBET voltage modulator 40 of Figure 4A, except that an R-C snubber 52 is included in the SBET voltage modulator 50. An R-C snubber 52 that includes resistor R2 and capacitor C2 is placed in shunt at the switched output node SW. The loss introduced by the resistor R2 while charging and discharging the switched output node SW can damp out the effect of the parasitic inductances in the system, yielding smaller settling transients at the switched output node SW. Charging and discharging the R-C snubber 52 may result in supply current transients for voltage supplies VDD1 and VDD2 that are larger than desired, which can result in unwanted power dissipation. The R-C snubber 52 may take a relatively long time to discharge.

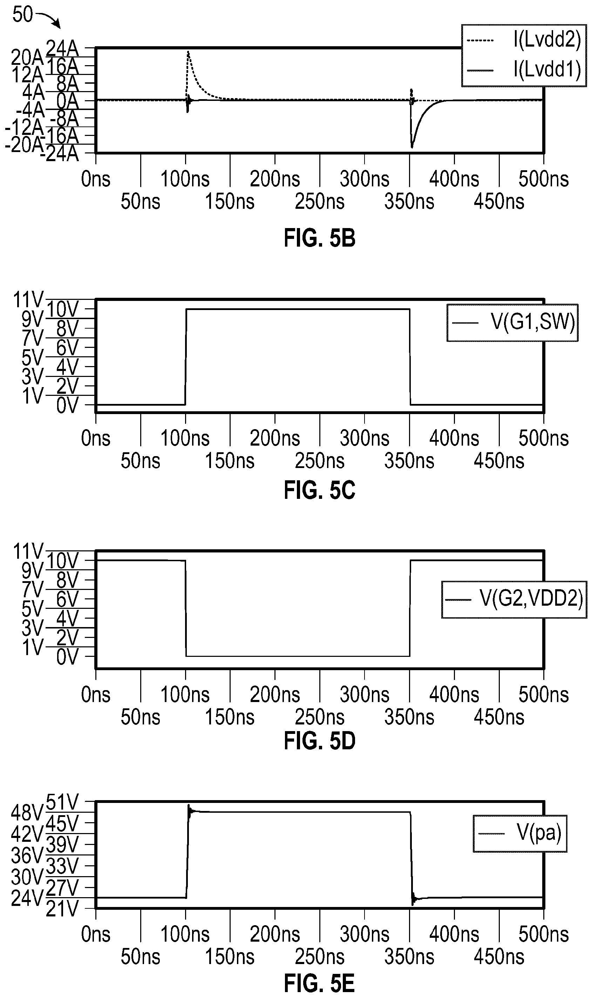

Figures 5B, 5C, 5D, and 5E are graphs associated with operation of the SBET voltage modulator 50 of Figure 5A. Figure 5B is a graph of current for the voltage supplies VDD1 and VDD2. Figure 5C is a graph of gate voltage for the first field effect transistor 42. Figure 5D is a graph of gate voltage for the second field effect transistor 44. Figure 5E is a graph of a bias voltage provided to a PA by the SBET voltage modulator 40. The R-C snubber 52 can damp-out settling transients for the bias voltage provided to the PA. This is reflected in the graph of Figure 5E. The supply current transit associated with switching the bias voltage the PA between the first supply voltage VDD1 and the second supply voltage VDD2 can be higher than desired. The supply current transient is shown in the graph of Figure 5B.

### Staged Activation of Switches of Voltage Modulator

To achieve desirable edge transitions with relatively small overshoot and relatively small supply current transients, switches of a voltage modulator be implemented by field effect transistors in parallel with each other. The parallel field effect transistors can be turned on at different times to provide desirable edge characteristics for bias voltage for the power amplifier. Such parallel switches can be implemented in voltage modulators arranged to generate SBET bias voltages can have transition times of 10s of ns and voltage can be stepped significantly by over 10 V or over 20 V from one state to another state.

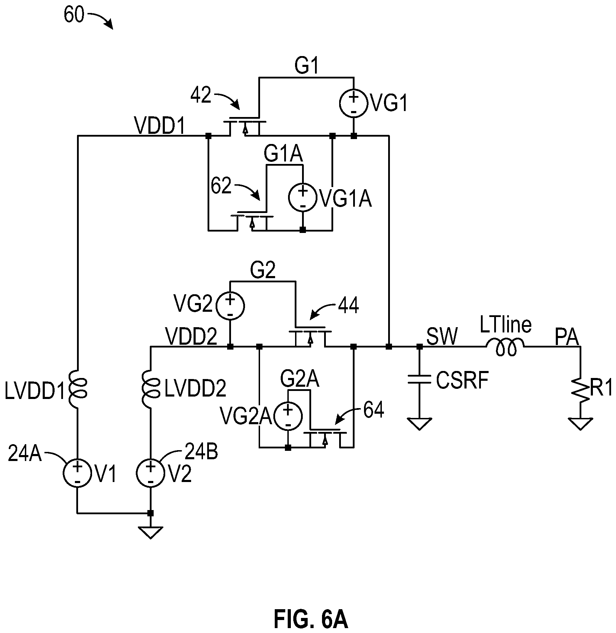

Figure 6A is a schematic diagram of an SBET voltage modulator 60 with switches implemented by parallel field effect transistors according to an embodiment. The SBET voltage modulator 60 is a technical solution to achieving desirable edge transitions at the output of a SBET voltage modulator with relatively minimal over-shoot and undershoot. The SBET voltage modulator 60 includes a first pair of effect transistors 42 and 62 and a second pair of field effect transistors 44 and 46. The field effect transistors 42, 62, 44, and 64 can be metal oxide semiconductor field effect transistors (MOSFETs). The field effect transistors 42, 62, 44, and 64 can be enhancement mode MOSFETs. The field effect transistors 42, 62, 44, and 64 can function as switches. The field effect transistors 62 and 64 are arranged in parallel with field effect transistors 42 and 44, respectively. The field effect transistors 62 and 64 may be substantially smaller than the field effect transistors 42 and 44, respectively, causing the field effect transistors 62 and 64 to have substantially more ON resistance. The field effect transistor 42 can occupy more physical area than the field effect transistor 62. In some instances, the field effect transistor 42 can have a gate width that is at least 4 times a gate with the field effect transistor 62. In certain applications, the field effect transistor 42 can have a gate width that is at least 8 times a gate with the field effect transistor 62. The field effect transistor 44 can occupy more physical area than the field effect transistor 64. In some instances, the field effect transistor 44 can have a gate width that is at least 4 times a gate with the field effect transistor 64. In certain applications, the field effect transistor 44 can have a gate width that is at least 8 times a gate with the field effect transistor 64.

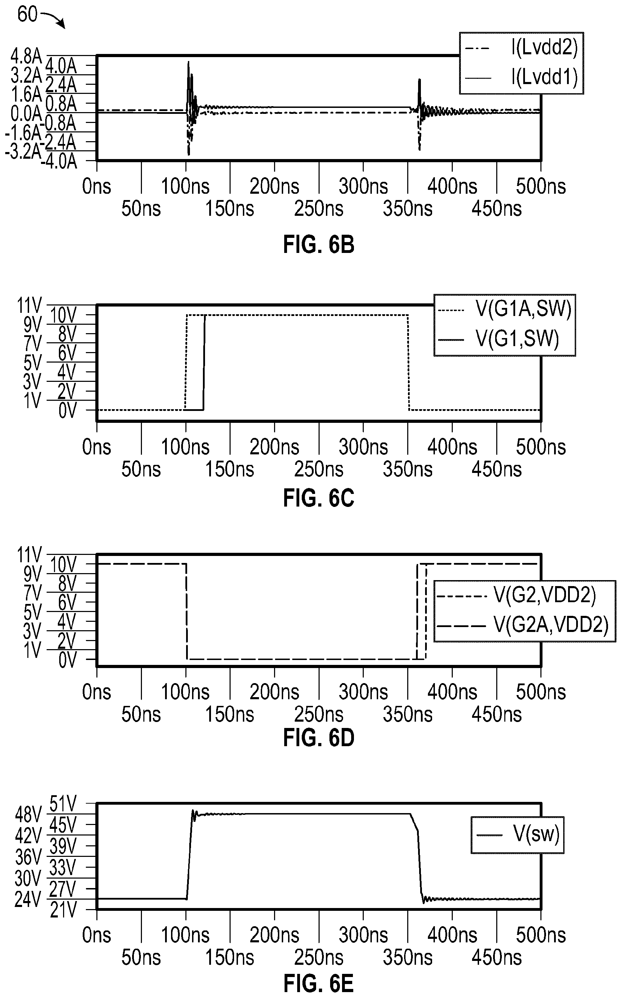

Figures 6B, 6C, 6D, and 6E are graphs associated with operation of the SBET voltage modulator 60 of Figure 6A. Figure 6B is a graph of current for the voltage supplies VDD1 and VDD2. Figure 6C is a graph of gate voltage for the field effect transistors 42 and 62. Figure 6D is a graph of gate voltage for the field effect transistors 44 and 46. Figure 6E is a graph of a bias voltage provided to a PA by the SBET voltage modulator 60.

The SBET voltage modulator 60 includes staged activation of switches. The SBET voltage modulator 60 is configured to receive a plurality of supply voltages VDD1 and VDD2. The SBET voltage modulator 60 is configured to output a selected one of the supply voltages VDD1 and VDD2 at a switched output node SW based on a SBET state. The SBET stats can correspond to a supply voltage of the plurality of supply voltages VDD1 and VDD2. The SBET state can correspond to a peak signal power of a symbol of an RF signal being amplified by a power amplifier. The peak power can be a peak root mean square (RMS) signal power. The SBET state can correspond to a peak composite power symbol of an RF signal amplified by a power amplifier, where the RF signal includes a plurality of carriers.

Each of the supply voltages VDD1 and VDD2 are non-zero voltages. The supply voltages VDD1 and VDD2 can differ from each other by at least 10 V. The supply voltage VDD2 with a lower voltage can have a voltage that is at least one quarter of the voltage of the supply voltage VDD1 with the higher voltage level. In some such instances, the supply voltage VDD2 with the lower voltage can have a voltage that is at least one half of the voltage of the the supply voltage VDD1 with the higher voltage level.

In the SBET voltage modulator 60, a first switch (e.g., field effect transistor 42) is in parallel with a second switch (e.g., field effect transistor 62). The first switch (e.g., field effect transistor 42) is configured to turn on after the second switch (e.g., field effect transistor 62) in association with the symbol-based envelope tracking state transitioning, for example, as indicated by Figure 6C. The first switch (e.g., field effect transistor 42) and the second switch e.g., field effect transistor 62) can pass the first supply voltage VDD1 when on. Figure 6E indicates that the first supply voltage VDD1 can be 48 V in an example application. In the SBET voltage modulator 60, a third switch (e.g., field effect transistor 44) can pass the second supply voltage VDD2 when on. Figure 6E indicates that the second supply voltage VDD2 can be 24 V in an example application.

At the instant of the switched output node SW rising-edge transition, the field effect transistor 62 is enhanced and the field effect transistors 44 and 64 are cut-off. This corresponds to the bias voltage of Figure 6B rising and first the gate voltage transitions in Figures 6C and 6D. A field effect transistor being enhanced can refer to the field effect transistor being on. A field effect transistor being cut-off can refer to turning off the field effect transistor.

The field effect transistors 44 and 64 may still be enhanced when the field effect transistor 62 is enhanced. This can be referred to as make before break switching.

The switched output node SW voltage can then rise through most of the transition band between the supply voltagesVDD2 and VDD1. The field effect transistor 42 is then enhanced completing the switched output node SW rising-edge transition with a relatively low or minimum settling error. Figure 6C illustrates the gate voltage of the field effect transistor 42 rising after the gate voltage of the field effect transistor 62.

At the instant of the falling-edge transition of the bias voltage, the field effect transistors 42 and 62 are both cutoff and the field effect transistor 64 is enhanced. This corresponds to the bias voltage of Figure 6E falling, the gate voltage in Figure 6C falling, and the gate voltage of the field effect transistor 64 rising in Figure 6D.

The field effect transistor 64 may be enhanced while field effect transistors 42 and 62 are still enhanced. The field effect transistor 44 is enhanced after the switched output node SW has transitioned to approximately the second supply voltage VDD2 thus completing the falling-edge transition with low or minimal settling error. While the make-before-break switching scheme may result in shoot-through current transients between the supply voltages VDD1 and VDD2, the resulting average power dissipation may not be significant and only the load capacitance 25 can be charged or discharged during the rising or falling-edge transitions, respectively.

The interval between enhancing the field effect transistors 62 and 42 may be a fixed delay, or the interval may be a function of the voltage at the switched output node SW. Similarly, the interval between enhancing the field effect transistors 64 and 44 may be fixed delay, or the interval may be a function of the voltage at the switched output node SW.

Staged enhancement can involve breaking the top gate and bottom gate field effect transistors into two or more parallel devices, one of which may be substantially smaller than the other(s). By then enhancing the smaller device and waiting for the switched output to rise or fall before enhancing the second device, ringing and overshoot of the switched output may be reduced and/or minimized. Staged enhancement may also reduce and/or minimize supply current spikes as well as power dissipation not directly related to changing the switched output voltage.

Staged activation is an efficient way to realize a SBET voltage modulator. Staged activation of field effect transistor (e.g., MOSFET) switches can drive a switched output node of the SBET voltage modulator without significant ringing and overshoots. An SBET voltage modulator with staged activation of the field effect transistor (e.g., MOSFET) switches can be realized as an integrated circuit.

Any of the switches of the voltage modulators disclosed herein can be split into sub-switches with magnetic field cancellation. Magnetic field cancellation can be implemented by current loops that generate magnetic fields in opposite directions. The sub-switches can include a pair of switches that are included in current loops with different bypass capacitors. The current loops can generate magnetic fields having opposite directions for magnetic field cancellation.

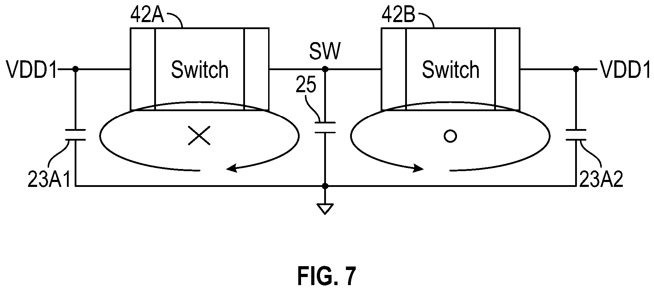

Figure 7 is a schematic diagram of a pair of switches 42A, 42B and associated bypass capacitors 23A1, 23A2 with magnetic field cancellation. A first current loop that includes the first switch 42A and the first bypass capacitor 23A1 can generate a first magnetic field in a first direction (e.g., into the plane of the page). A second current loop that includes the second switch 42B and the second bypass capacitor 23A2 can generate a second magnetic field in a second direction (e.g., out of the plane of the page), where the second direction is opposite to the first direction. The first and second magnetic fields are opposing magnetic fields that can cancel each other. The first and second magnetic fields can have approximately the same magnitude and opposite directions for such cancellation. Magnetic field cancellation can be significant, even though such magnetic field cancellation may not completely cancel the first and second magnetic fields. The lower magnetic field from magnetic field from cancellation can reduce inductance.

The stage activation of switches disclosed herein can be applied to switches of a voltage modulator that are implemented as common drain switches. A switch of a voltage modulator can be implemented by common drain switches can connect an output node of a voltage modulator to a supply voltage. The common drain switches can be common-drain, back-to-back MOSFET switches. A smaller switch can be in parallel with the switch that includes a pair of common drain switches, where the smaller switch can activate before the switch that includes the pair of common drain switches to implement staged activation in accordance with any suitable principles and advantages disclosed herein. The smaller switch can include common drain switches in some applications. In some instances, the smaller switch can include be in parallel with one of the common drain switches.

Although embodiment disclosed herein may be discussed with reference to field effect transistor switches or MOSFET switches, any other suitable switches can alternatively or additionally be implemented in accordance with any suitable principles and advantages disclosed herein. Such switches can include without limitation transistors, field effect transistors, complementary metal oxide semiconductor (CMOS) transistors, junction field effect transistors, integrated gate bipolar transistors, diode switches, microelectromechanical systems switches, or the like.

Although embodiments disclosed herein may be discussed with reference to SBET voltage modulators with 2 voltage supplies, any suitable principles and advantages disclosed herein can be applied to SBET voltage modulators with 3 or more voltage supplies. As one example, any suitable principles and advantages disclosed herein can be applied to an SBET voltage modulator that can selectively provide one of four non-zero supply voltages as an output voltage.

### Conclusion

In the embodiments described above, apparatus, voltage modulators systems, and methods for systems and/or SBET voltage modulators are described in connection with particular embodiments. It will be understood, however, that the principles and advantages of the embodiments can be used for any other systems, apparatus, or methods with a need for a voltage modulator and/or envelope tracking disclosed herein. Moreover, any suitable principles and advantages disclosed herein can be implemented in systems and in methods that include a power amplifier amplifying a radio frequency signal for transmission via an antenna.

The principles and advantages described herein can be implemented in various apparatuses. Examples of such apparatuses can include, but are not limited to, communications infrastructure such as wireless or wired communications infrastructure, consumer electronic products, parts of the consumer electronic products, electronic test equipment, vehicular electronic products, industrial electronic products, etc. Electronic products can include, but are not limited to, base stations such as cellular base stations, access points, repeaters, relays, wireless communication devices, a mobile phone (for example, a smart phone), a hand-held computer, a tablet computer, a laptop computer, a wearable computing device, a vehicular electronics system, a radio, a wearable health monitoring device, an Internet of Things (IoT) device, etc. Further, apparatuses can include unfinished products.

Unless the context clearly requires otherwise, throughout the description and the claims, the words "comprise," "comprising," "include," "including," and the like are to be construed in an inclusive sense, as opposed to an exclusive or exhaustive sense; that is to say, in the sense of "including, but not limited to." The words "coupled" or connected", as generally used herein, refer to two or more elements that may be either directly connected, or connected by way of one or more intermediate elements. Additionally, the words "herein," "above," "below," and words of similar import, when used in this application, shall refer to this application as a whole and not to any particular portions of this application. Where the context permits, words in the Detailed Description using the singular or plural number may also include the plural or singular number, respectively. The words "or" in reference to a list of two or more items, is intended to cover all the following interpretations of the word: any of the items in the list, all the items in the list, and any combination of the items in the list. All numerical values provided herein are intended to include similar values within a measurement error.

Moreover, conditional language used herein, such as, among others, "can," "could," "might," "may," "e.g.," "for example," "such as" and the like, unless specifically stated otherwise, or otherwise understood within the context as used, is generally intended to convey that certain embodiments include, while other embodiments do not include, certain features, elements and/or states.

The teachings provided herein can be applied to other systems, not necessarily the systems described above. The elements and acts of the various embodiments described above can be combined to provide further embodiments. The acts of the methods discussed herein can be performed in any order as appropriate. Moreover, the acts of the methods discussed herein can be performed serially or in parallel, as appropriate.

While certain embodiments have been described, these embodiments have been presented by way of example only and are not intended to limit the scope of the disclosure. Indeed, the novel methods and systems described herein may be embodied in a variety of other forms. Furthermore, various omissions, substitutions, and changes in the form of the methods and systems described herein may be made without departing from the spirit of the disclosure. For example, while the disclosed embodiments are presented in given arrangements, alternative embodiments may perform similar functionalities with different components and/or circuit topologies, and some elements may be deleted, moved, added, subdivided, combined, and/or modified. Each of these elements may be implemented in a variety of different ways as suitable. Any suitable combination of the elements and acts of the various embodiments described above can be combined to provide further embodiments. The accompanying claims and their equivalents are intended to cover such forms or modifications as would fall within the scope and spirit of the disclosure.

There follows a list if numbered features defining particular embodiments of the present disclosure. Where a numbered feature refers to one or more earlier numbered features then those numbered features may be considered together in combination with each other.
1. A system with staged activation of switches for symbol-based envelope tracking, the system comprising:
   a voltage modulator configured to receive a plurality of supply voltages and to output a selected one of the plurality of supply voltages at an output node based on a symbol-based envelope tracking state, the voltage modulator comprising:
      a first switch;
      a second switch in parallel with the first switch, wherein the first switch is configured to activate after the second switch in association with the symbol-based envelope tracking state transitioning from a first state to a second state, and wherein the first switch and the second switch are configured to pass a first supply voltage to the output node in the second state; and
      a third switch configured to pass a second supply voltage to the output node in the first state; and
   a power amplifier electrically connected to the output node, the power amplifier configured to amplify a radio frequency signal.
2. The system of feature 1, wherein the first switch occupies more physical area than the second switch.
3. The system of feature 1 or 2, wherein the voltage modulator comprises a fourth switch in parallel with the third switch, wherein the third switch is configured to activate after the fourth switch in association with the symbol-based envelope tracking state transitioning from the second state to the first state.
4. The system of any of features 1 to 3, wherein the power amplifier comprises a gallium nitride transistor.
5. The system of any of features 1 to 4, wherein a voltage at the output node has a higher voltage level in the second state than in the first state, wherein the voltage at the output node in the first state is greater than 0 Volts, and wherein the voltage at the output node in the first state is at least one quarter of the voltage at the output node in the second state.
6. The system of any of features 1 to 5, wherein the first switch and the second switch are field effect transistors.
7. The system of any of features 1 to 6, wherein the first switch comprises a pair of sub-switches with magnetic field cancellation.
8. The system of any of features 1 to 7, wherein the voltage modulator is configured to perform make before break switching.
9. The system of any of features 1 to 8, wherein the voltage modulator is configured to transition a voltage at the output node between the first supply voltage and the second supply voltage in less than 50 nanoseconds, and wherein the first supply voltage and the second supply voltage differ by at least one quarter of a higher of the first supply voltage and the second supply voltage.
10. The system of any of features 1 to 9, wherein a voltage at the output node tracks an envelope of the radio frequency signal on a symbol-by-symbol basis.
11. A method of voltage multiplexing with staged activation of switches, the method comprising:
   providing a first supply voltage of a plurality of supply voltages as an output voltage using a switch in a first state;
   activating a pair of parallel switches in association with transitioning from the first state to a second state such that a second switch of the pair of parallel switches activates before a first switch of the pair of parallel switches; and
   providing a second supply voltage of the plurality of supply voltages as the output voltage using the pair of parallel switches in the second state, wherein the first supply voltage and the second supply voltage are at different discrete non-zero voltage levels when provided as the output voltage.
12. The method of feature 6, further comprising biasing a power amplifier with the output voltage and amplifying a radio frequency signal with the power amplifier.
13. The method of feature 7, wherein the first state and the second state are symbol-based envelope tracking states associated with symbols of the radio frequency signal.
14. The method of any of features 7 or 13, wherein the output voltage tracks an envelope of the radio frequency signal on a symbol-by-symbol basis.
15. The method of any of features 6 to 14, wherein the activating occurs on a symbol boundary of a radio frequency signal amplified by a power amplifier that receives the output voltage.
16. The method of any of features 6 to 15, wherein the first switch occupies more physical area than the second switch.
17. The method of any of features 6 to 16, further comprising activating a second pair of parallel switches in association with transitioning from the second state to the first state such that a fourth switch activates before a third switch, wherein the second pair of parallel switches comprises the third switch and the fourth switch.
18. A voltage modulator with staged activation of switches, the voltage modulator comprising:
   a first switch;
   a second switch in parallel with the first switch, wherein the first switch is configured to activate after the second switch in association with transitioning from a first state to a second state, and wherein the first switch and the second switch are configured to pass a first supply voltage to an output node in the second state; and
   a third switch configured to pass a second supply voltage to the output node in the first state, wherein the voltage modulator is configured to receive a plurality of non-zero supply voltages including the first supply voltage and the second supply voltage.
19. The voltage modulator of feature 13, wherein the voltage modulator is configured to perform make before break switching, and wherein the first switch occupies more physical area than the second switch.
20. The voltage modulator of feature 13 or 19, wherein the first switch comprises a pair of sub-switches with magnetic field cancellation

## Claims

1. A system with staged activation of switches for symbol-based envelope tracking, the system comprising:
a voltage modulator configured to receive a plurality of supply voltages and to output a selected one of the plurality of supply voltages at an output node based on a symbol-based envelope tracking state, the voltage modulator comprising:
a first switch;
a second switch in parallel with the first switch, wherein the first switch is configured to activate after the second switch in association with the symbol-based envelope tracking state transitioning from a first state to a second state, and wherein the first switch and the second switch are configured to pass a first supply voltage to the output node in the second state; and
a third switch configured to pass a second supply voltage to the output node in the first state; and
a power amplifier electrically connected to the output node, the power amplifier configured to amplify a radio frequency signal.

2. The system of Claim 1, wherein the voltage modulator comprises a fourth switch in parallel with the third switch, wherein the third switch is configured to activate after the fourth switch in association with the symbol-based envelope tracking state transitioning from the second state to the first state.

3. The system of any of Claims 1 or 2, wherein a voltage at the output node has a higher voltage level in the second state than in the first state, wherein the voltage at the output node in the first state is greater than 0 Volts, and wherein the voltage at the output node in the first state is at least one quarter of the voltage at the output node in the second state.

4. The system of any of Claims 1 to 3, wherein one or more of the following appy:
a) the first switch and the second switch are field effect transistors;
b) the first switch comprises a pair of sub-switches with magnetic field cancellation; and/or
c) the voltage modulator is configured to perform make before break switching.

5. The system of any of Claims 1 to 4, wherein the voltage modulator is configured to transition a voltage at the output node between the first supply voltage and the second supply voltage in less than 50 nanoseconds, and wherein the first supply voltage and the second supply voltage differ by at least one quarter of a higher of the first supply voltage and the second supply voltage.

6. A method of voltage multiplexing with staged activation of switches, the method comprising:
providing a first supply voltage of a plurality of supply voltages as an output voltage using a switch in a first state;
activating a pair of parallel switches in association with transitioning from the first state to a second state such that a second switch of the pair of parallel switches activates before a first switch of the pair of parallel switches; and
providing a second supply voltage of the plurality of supply voltages as the output voltage using the pair of parallel switches in the second state, wherein the first supply voltage and the second supply voltage are at different discrete non-zero voltage levels when provided as the output voltage.

7. The method of Claim 6, further comprising biasing a power amplifier with the output voltage and amplifying a radio frequency signal with the power amplifier.

8. The method of Claim 7, wherein the first state and the second state are symbol-based envelope tracking states associated with symbols of the radio frequency signal.

9. The system of any of claims 1 to 5 or the method of any of Claims 7 or 8, wherein the output voltage tracks an envelope of the radio frequency signal on a symbol-by-symbol basis.

10. The method of any of Claims 6 to 9, wherein the activating occurs on a symbol boundary of a radio frequency signal amplified by a power amplifier that receives the output voltage.

11. The system of any of claims 1 to 5, or the method of any of Claims 6 to 10, wherein the first switch occupies more physical area than the second switch.

12. The method of any of Claims 6 to 11, further comprising activating a second pair of parallel switches in association with transitioning from the second state to the first state such that a fourth switch activates before a third switch, wherein the second pair of parallel switches comprises the third switch and the fourth switch.

13. A voltage modulator with staged activation of switches, the voltage modulator comprising:
a first switch;
a second switch in parallel with the first switch, wherein the first switch is configured to activate after the second switch in association with transitioning from a first state to a second state, and wherein the first switch and the second switch are configured to pass a first supply voltage to an output node in the second state; and
a third switch configured to pass a second supply voltage to the output node in the first state, wherein the voltage modulator is configured to receive a plurality of non-zero supply voltages including the first supply voltage and the second supply voltage.

14. The voltage modulator of Claim 13, wherein the voltage modulator is configured to perform make before break switching, and wherein the first switch occupies more physical area than the second switch.

15. The voltage modulator of Claim 13 or 14, wherein the first switch comprises a pair of sub-switches with magnetic field cancellation.
